# EUROPÄISCHE PATENTSCHRIFT

(11) **EP 2 519 986 B1**
(45) Veröffentlichungstag und Bekanntmachung des Hinweises auf die Patenterteilung: **12.09.2018**
(21) Anmeldenummer: 10784718.8
(22) Anmeldetag: 01.12.2010
(51) Int. Cl.: H01L 33/56, H01L 33/50

(54) **VERGUSSMASSE ALS DIFFUSIONSBARRIERE FÜR WASSERMOLEKÜLE**
POTTING COMPOUND AS A DIFFUSION BARRIER FOR WATER MOLECULES
MATÉRIAU D'ENROBAGE EN TANT QUE BARRIÈRE DE DIFFUSION ENVERS DES MOLÉCULES D'EAU

(30) Priorität: 30.12.2009 EP 09016115
(43) Veröffentlichungstag der Anmeldung: 07.11.2012
(73) Patentinhaber: Merck Patent GmbH, 64293 Darmstadt (DE)
(72) Erfinder: PETRY, Ralf, 64347 Griesheim (DE); WINKLER, Holger, 64291 Darmstadt (DE); VOSGROENE, Tim, 64372 Ober-Ramstadt (DE)
(86) Internationale Anmeldenummer: PCT/EP2010/007271
(87) Internationale Veröffentlichungsnummer: WO 2011/079900

(56) Entgegenhaltungen:
- US-A- 6 066 861
- US-A1- 2004 207 998
- US-A1- 2008 210 961
- US-A1- 2009 261 708

## Beschreibung

Die Erfindung betrifft eine Vergussmasse auf der Basis eines transparenten Epoxy- oder Siliconharzes für Verwendungen in einem elektrolumineszierenden Bauelement, welches vorzugsweise weißes Licht aussendet sowie ein Verfahren zur Herstellung derartiger Vergussmassen. Die Vergussmasse dient dabei durch den Einsatz von Glas- oder Silicaplättchen als Diffusionsbarriere für Wassermoleküle. Kommerzielle weiße pc-LEDs bestehen aus einem Chip, der im blauen Spektralbereich emittiert und einer Beschichtung bestehend aus Silicon- oder Epoxyharz, in der sich ein oder mehrere Leuchtstoffe befinden.

Die Leuchtstoffe basieren häufig auf Silikatischen, Sulfidischen, Nitridischen oder Oxynitiridischen Materialien. Diese Materialien haben die Eigenschaft, dass sie sich in Gegenwart von geringsten Spuren von Feuchtigkeit zersetzen.

Bei den ortho-Silikatleuchtstoffen trifft dies insbesondere auf die grünen, hohe Konzentrationen an Barium enthaltenden Leuchtstoffe zu. Die in der Luft enthaltene Feuchtigkeit diffundiert durch die Silicon- bzw. Epoxyharz-Matrix zu den Leuchtstoff-Partikeln. Dies hat zur Konsequenz, dass bedingt durch die Zersetzung des Leuchtstoffes dessen Helligkeit mit der Zeit abnimmt und degradiert. Damit einher geht die Abnahme der Performance der weißen pc-LED: Zum einen ändert sich der Farbpunkt der LED. Des Weiteren werden bei der LED der Chip, vorhandene Reflektoren und die elektrischen Anschlüsse durch die Hydrolyseprodukte von sulfidischen bzw. (oxy-)nitridischen Leuchtstoffen korrosiv zerstört.

Die durch den notwendigen Austausch der LED entstehenden Kosten behindern die schnelle Substitution von uneffizienten und mit kurzer Lebensdauer behafteten Glühbirnen, Halogenlampen und Fluoreszenzlampen durch weiße LEDs.

Aus EP 862794 ist eine wellenlängenkonvertierende Vergussmasse bekannt, die aus Epoxyharz besteht und anorganische Leuchtstoffpigmente enthält. Zur Verminderung der Agglomeratbildung können die Leuchtstoffpigmente mit einem Silicon-Coating versehen werden.

Aufgabe der vorliegenden Erfindung ist es daher, Vergussmassen zur Verfügung zu stellen, die einen oder mehrere der oben genannten Nachteile nicht aufweisen.

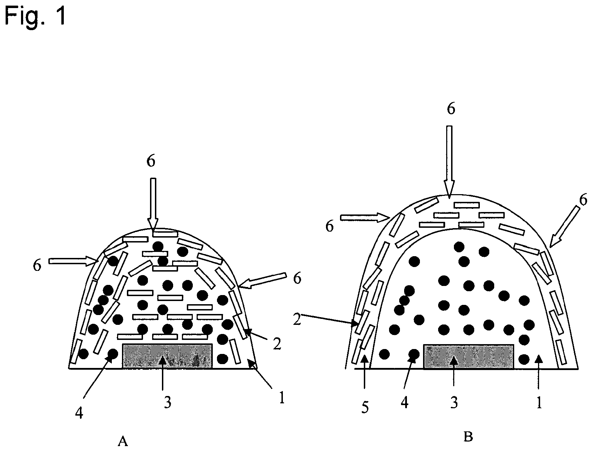

Überraschenderweise wurde jetzt gefunden, dass die, durch Spuren von diffundierendem Wasser verursachte, Zersetzung des Leuchtstoffes innerhalb der Vergussmasse aus einer Silicon- oder Epoxyharz-Matrix durch das Einbringen von plättchenförmigen anorganischen Partikeln in die Matrix verhindert werden kann. Die plättchenförmigen Partikel, die aus Glas oder Silica bestehen, wirken als effiziente Diffusionsbarriere für die Wassermoleküle. Des weiteren können die plättchenförmigen Partikel im Silicon- oder Epoxyharz dispergiert werden und als separate Diffusionssperrschicht direkt auf die Leuchtstoffbeschichtung der LED aufgebracht werden. (Abbildung 1A bzw. 1B) Die Erfindung wird in den unabhängigen Ansprüchen definiert. Vorteilhafte Weiterbildungen der Erfindung sind in den zugehörigen abhängigen Ansprüchen angegeben.

Gegenstand der vorliegenden Erfindung ist somit ein elektrolumineszierendes Bauelement mit einer Vergussmasse auf der Basis mindestens eines transparenten Silicon- oder Epoxyharzes enthaltend anorganische Leuchtstoffpartikel sowie plättchenförmige Glas- und/oder Silicapartikel, auf einer UV- oder blauen Leuchtdiode.

In einer bevorzugten Ausführungsform sind die Glas- oder Silicapartikel und die Leuchtstoffpartikel in der Vergussmasse homogen verteilt (siehe Abb. 1 A)

In einer weiteren bevorzugten Ausführungsform sind die plättchenförmigen Glas- oder Silicapartikel in der Vergussmasse dispergiert und planparallel ausgerichtet und als separate Diffusionssperrschicht direkt auf einer zusätzlichen Vergussmasse, welche ausschließlich die Leuchtstoffpartikel enthält, angeordnet.(siehe Abb. 1B) Erfindungsgemäß besitzen die Glas- und Silicapartikel einen Durchmesser von 5 bis 20 µm und eine Dicke von 0,1 bis 5 µm.

Vorzugsweise liegt der mittlere Korndurchmesser d₅₀ der Leuchtstoffpartikel < 20µm.

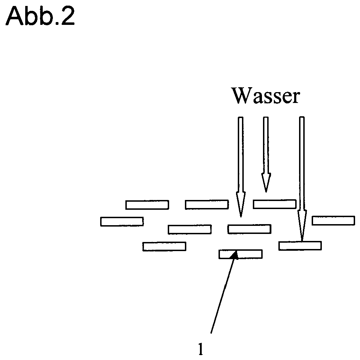

Der Effekt der plättchenförmigen Glas- und Silica-Partikel beruht darauf, dass der Diffusionsweg der Wassermoleküle in der Vergussmasse aus Silicon- oder Epoxyharz-Matrix blockiert wird. Dies geschieht durch planparallele Ausrichtung der Partikel in bestimmten Domänen sowie durch die versetzte Anordnung der Plättchen in vertikaler Richtung. (siehe Abb. 2) Aufgrund der Tatsache, dass Glas- bzw. Silica-Partikel annähernd die Brechzahl der Silicon- bzw. Epoxyharz-Matrix im Bereich von n = 1,4 - 1,5 aufweisen, werden die optischen Eigenschaften der weißen LED nicht negativ beeinflusst. Durch die geringfügig streuenden Eigenschaften der plättchenförmigen Partikel (Effekt der Partikelkanten) verbessert sich die Homogenität der Helligkeit und Farbtemperatur über den Winkelbereich der weißen LED.

Zur Verbesserung der Dispergierbarkeit der plättchenförmigen Glas- und/oder Silica-Partikel innerhalb des Epoxy- bzw. Siliconharzes können die Partikel oberflächenbeschichtet werden. Die plättchenförmigen Partikel werden dann mit Siliconen/ Silanen nasschemisch oder durch Aufdampfen beschichtet. Diese Silicium-organischen Verbindungen reagieren mit den Oberflächen- OH-Gruppen der plättchenförmigen Partikel. Durch Modifizierung der organischen Ketten der Siliziumverbindungen wird die gewünschte Hydrophobie der Partikel, Struktur der Oligomer / Polymerketten und die Ankopplung (physikalisch und /oder chemisch) an das Harz gesteuert.

Vorzugsweise bestehen die Leuchtstoffpartikel aus mindestens einem der folgenden Leuchtstoffmaterialien:
(Y, Gd, Lu, Sc, Sm, Tb)₃ (AI, Ga)₅O₁₂:Ce (mit oder ohne Pr), (Ca, Sr, Ba)₂SiO₄:Eu, YSiO₂N:Ce, Y₂Si₃O₃N₄:Ce, Gd₂Si₃O₃N₄:Ce, (Y,Gd,Tb,Lu)₃Al₅₋ₓSiₓO₁₂₋ₓNₓ:Ce, BaMgAl₁₀O₁₇:Eu, SrAl₂O₄:Eu, Sr₄Al₁₄O₂₅:Eu, (Ca,Sr,Ba)Si₂N₂O₂:Eu, SrSiAl₂O₃N₂:Eu, (Ca,Sr,Ba)₂Si₅N₈:Eu, CaAlSiN₃:Eu, Zink-Erdalkaliorthosilikate, Kupfer-Erdalkaliorthosilikate, Eisen-Erdalkaliorthosilikate, Molybdate, Wolframate, Vanadate, Gruppe-III Nitride, Oxide, jeweils einzeln oder Gemischen derselben mit einem oder mehreren Aktivatorionen wie Ce, Eu, Mn, Cr und/oder Bi.

Besonders bevorzugte anorganische Leuchtstoffpartikel zur Herstellung von weiß leuchtenden optoelektronischen Bauelementen sind ortho-Silikate.

Die Edukte zur Herstellung des Leuchtstoffpartikel bestehen aus dem Basismaterial (z.B. Salzlösungen des Yttrium, Aluminiums, Gadoliniums etc.) sowie mindestens einem Dotierstoff (z.B. Cer). Als Edukte kommen anorganische und/oder organische Stoffe wie Nitrate, Halogenide, Carbonate, Hydrogencarbonate, Phosphate, Carboxylate, Alkoholate, Acetate, Oxalate, Sulfate, metallorganische Verbindungen, Hydroxide und/oder Oxide der Metalle, Halbmetalle, Übergangsmetalle und/oder Seltenerden in Frage, welche in anorganischen und/oder organischen Flüssigkeiten gelöst und/oder suspendiert sind. Vorzugsweise werden Mischnitratlösungen, Chlorid- oder Hydroxidlösungen eingesetzt, welche die entsprechenden Elemente im erforderlichen stöchiometrischen Verhältnis enthalten.

Weiterhin wird die Aufgabe gemäß der Erfindung gelöst durch ein Verfahren zur Herstellung eines elektrolumineszierenden Bauelements mit einer Vergussmasse auf der Basis mindestens eines transparenten Silicon- oder Epoxyharzes enthaltend anorganische Leuchtstoffpartikel sowie Glas- und/oder Silicapartikel auf einer UV- oder blauen Leuchtdiode, gekennzeichnet durch die Verfahrensschritte:
a) Homogenes Mischen anorganischer Leuchtstoffpartikel mit pulverförmigen Glas- und/oder Silicapartikeln
b) Dispergieren der Mischung aus Leuchtstoffen und Glas- oder Silicapartikeln mit dem transparenten Silicon- oder Epoxyharz.
c) Beschichten der blauen Leuchtdiode mit Silicon- oder Epoxyharz, welches den Leuchtstoff und die Glas- und/oder Silica-Partikel enthält.
d) Aushärten der Beschichtung.

Das Aushärten der Beschichtung erfolgt bei Temperaturen zwischen 120 und 180 °C, vorzugweise bei 150°C
Die Herstellung der Glas- und Silica-Partikel geschieht nach herkömmlichen Verfahren über einen Bandprozess aus den entsprechenden Alkalisalzen (z.B für Silica aus einer Kalium- oder Natronwasserglas-Lösung). Das Herstellverfahren ist ausführlich in EP 763573, EP 608388 und DE 19618564 beschrieben.

Gegenstand der vorliegenden Erfindung ist weiterhin ein Verfahren zur Herstellung eines elektrolumineszierenden Bauelements mit einer Vergussmasse auf der Basis mindestens eines transparenten Silicon- oder Epoxyharzes enthaltend anorganische Leuchtstoffpartikel sowie Glas- und/oder Silicapartikel auf einer UV- oder blauen Leuchtdiode, gekennzeichnet durch die Verfahrensschritte:
a) Dispergieren der anorganischen Leuchtstoffpartikel mit Silicon- oder Epoxyharz.
b) Beschichten der Leuchtdiode mit der Mischung aus Leuchtstoffpartikel und Silicon- oder Epoxyharz.
c) Aushärten der Beschichtung.
d) Dispergieren der Glas- und/oder Silicapartikel in Silicon- oder Epoxyharz.
e) Herstellen einer Diffusionssperrschicht durch Beschichten der ausgehärteten Leuchtstoffbeschichtung.
f) Aushärten der Diffusionssperrschicht.

Weiterhin bevorzugt ist es, wenn die plättchenförmigen Glas- oder Silicapartikel mit Silicium-organischen Verbindungen (wie Siliconen oder Silanen) nasschemisch oder durch Aufdampfen oberflächenbeschichtet werden. Wie schon erwähnt, wird durch diese Beschichtung die Ankopplung an das Epoxy- oder Siliconharz verbessert.

Der Vergussmasse können zusätzlich lichtstreuende Partikel, sogenannte Diffusoren (wie z.B. CaF₂) zugesetzt sein. Hierdurch lässt sich vorteilhafterweise der Farbeindruck und die Abstrahlcharakteristik des Halbleiterbauelements weiter optimieren.

Zusätzlich kann die Vergussmasse noch Haftvermittler, Hydrophobiermittel, Verarbeitungshilfsmittel und/oder Thixotropiermittel enthalten. Als Thixotropiermittel kann z.B. pyrogene Kieselsäure verwendet werden. Das Thixotropiermittel dient zur Eindickung des Epoxyharzes, um die Sedimentation der Leuchtstoffpartikel zu vermindern. Als Verarbeitungshilfsmittel eignet sich z.B. Glykolether.
Als Haftvermittler kann z.B. funktionelles Alkoxysiloxan eingesetzt werden, welches die Haftung zwischen Leuchtstoffpartikeln und Harz verbessert. Als Hydrophobiermittel können z.B. flüssiges Silikonwachs eingesetzt werden, welches ebenfalls der Modifikation der Leuchtstoffpartikel-Oberfläche dient.

Bei der erfindungsgemäßen UV- oder blauen Leuchtdiode handelt es sich um eine Lichtquelle aus einem lumineszenten IndiumAluminiumGalliumNitrid, insbesondere der Formel InᵢGaⱼAlₖN, wobei 0 ≤ i, 0 ≤ j, 0 ≤ k, und i+j+k=1 ist.

Dem Fachmann sind mögliche Formen von derartigen Lichtquellen bekannt. Es kann sich hierbei um lichtemittierende LED-Chips unterschiedlichen Aufbaus handeln.

Die folgenden Beispiele sollen die vorliegende Erfindung verdeutlichen. Sie sind jedoch keinesfalls als limitierend zu betrachten. Alle Verbindungen oder Komponenten, die in den Zubereitungen verwendet werden können, sind entweder bekannt und käuflich erhältlich oder können nach bekannten Methoden synthetisiert werden. Die in den Beispielen angegebenen Temperaturen gelten immer in °C. Es versteht sich weiterhin von selbst, dass sich sowohl in der Beschreibung als auch in den Beispielen die zugegebenen Mengen der Komponenten in den Zusammensetzungen immer zu insgesamt 100% addieren. Gegebene Prozentangaben sind immer im gegebenen Zusammenhang zu sehen. Sie beziehen sich üblicherweise aber immer auf die Masse der angegebenen Teil- oder Gesamtmenge.

### Beispiele

### Beispiel 1: Beschichtung von plättchenförmigen Glas- bzw. Silicapartikel mit funktionellen Gruppen

### 1. A) Silanisierung für Epoxypolymere:

100 g der Silica- bzw. Glaspartikel werden in 1350 ml VE- Wasser unter intensivem Rühren suspendiert. Der pH-Wert der Suspension wird mit 5 wt % H₂SO₄ auf pH=6.5 eingestellt und die Suspension auf 75°C erhitzt. Anschließend werden 4,0 g eines 1:1-Gemisches von Silquest A-186 [beta-(3,4-Epoxy cyclohexyl)ethyltrimethoxysilan] und Silquest A-1310 [Gammaisocyanatopropyltriethoxysilan] innerhalb von 60 min bei moderatem Rühren zur Suspension dazudosiert. Nach erfolgter Zugabe wird anschließend 15 min gerührt, um die Ankopplung der Silane an die Oberfläche zu vervollständigen. Der pH-Wert wird mittels 5 wt % H₂SO₄ auf 6.5 korrigiert.

Die Suspension wird anschließend abfiltriert und mit VE-Wasser salzfrei gewaschen. Die Trocknung erfolgt 20 h bei 130°C. Das so erhaltene Pulver wird dann mittels 40 µm Sieb gesiebt.

### 1. B) Silanisierung für Siliconharz- Ankopplung:

100 g der Silica- bzw. Glaspartikel werden in 1350 ml VE- Wasser unter intensivem Rühren suspendiert. Der pH-Wert der Suspension wird mit 5 wt % H₂SO₄ auf pH=6.5 eingestellt und die Suspension auf 75°C erhitzt. Anschließend werden 6,0 g eines 1:2-Gemisches von Silquest A-1110 [gamma-aminopropytrimethoxysilan] und Silquest A-1524 [Gamma-Harnstoffpropyltrimethoxysilan] innerhalb von 75 min bei moderatem Rühren zur Suspension dazudosiert. Nach erfolgter Zugabe wird anschließend 15 min gerührt, um die Ankopplung der Silane an die Oberfläche zu vervollständigen. Der pH-Wert wird mittels 5 wt % H₂SO₄ auf 6.5 korrigiert.

Die Suspension wird anschließend abfiltriert und mit VE-Wasser salzfrei gewaschen. Die Trocknung erfolgt 20 h bei 140°C. Das so erhaltene Pulver wird dann mittels 40 µm Sieb gesiebt.

### 1. C) Silanisierung mit einem Vinylsilan für Siliconharz- Ankopplung:

100 g der Silica- bzw. Glaspartikel werden in 1350 ml VE- Wasser unter intensivem Rühren suspendiert. Der pH-Wert der Suspension wird mit 5 wt % H₂SO₄ auf pH= 6.8 eingestellt und die Suspension auf 75°C erhitzt.

Anschließend werden 6,0 g eines 1:2-Gemisches von Silquest A-174[Gamma-Methacryloxypropyltrimethoxysilan] und Silquest A-151[vinyltriethoxysilan] innerhalb von 90 min bei moderatem Rühren zur Suspension dazudosiert. Nach erfolgter Zugabe wird anschließend 15 min gerührt, um die Ankopplung der Silane an die Oberfläche zu vervollständigen. Der pH-Wert wird mittels 5 wt % H₂SO₄ auf 6.5 korrigiert. Die Suspension wird anschließend abfiltriert und mit VE-Wasser salzfrei gewaschen. Die Trocknung erfolgt 20 h bei 140°C.Das so erhaltene Pulver wird dann mittels 40 µm Sieb gesiebt.

### Beispiel 2: Herstellung einer LED

### A) Mischung von Leuchtstoff mit plättchenförmigen Partikeln

Es werden die folgenden Mischungen in einem Speedmixer ® (Drehzahl 3000 UpM, Zeitdauer: 5 min, Raumtemperatur) hergestellt:
Je 50 ml der beiden Harzkomponenten JCR 6122 a und b werden 4 Gew. % eines der grünen ortho-Silikatleuchtstoffes und 2 % unbeschichtete Glas- bzw. Silicapartikel bzw. die nach Beispiel 1 A, B, oder C kompatibilisierten plättchenförmigen Partikel zugemischt. Die plättchenförmigen Partikel weisen einen mittleren Durchmesser von 5 µm bis 20 µm und eine Dickenverteilung von 0,1 µm bis 5 µm auf. Die beiden Harzmischungen werden vereinigt, gerührt und entgast. Danach werden 10 ml in das Vorratsgefäß eines Jetdispensers oder Schraubendosierventildispensers gefüllt. Unter das Dispensventil werden gebondete COB (Chip on Board) Roh-LED packages platziert. Nun werden mit dem Dispenser glob tops aus der Harzmischung auf die Chips der Roh-LED packages getropft. Diese beschichteten LEDs werden im Trockenschrank bei 150°C über 1 Stunde temperiert. Dabei härtet das Harz (= Vergussmasse) aus.

### B) Separate Diffusionssperrschicht

Es werden die folgenden Mischungen in einem Speedmixer ® (Drehzahl 3000 UpM, Zeitdauer: 5 min, Raumtemperatur) hergestellt:
Je 50 ml der beiden Harzkomponenten JCR 6122 a und b werden 4 Gew. % eines grünen ortho-Silikatleuchtstoffes zugemischt. Die beiden Harzmischungen werden vereinigt, gerührt und entgast. Danach werden 10 ml in das Vorratsgefäß eines Jetdispensers oder Schraubendosierventildispensers gefüllt. Unter das Dispensventil werden gebondete COB (Chip on Board) Roh-LED packages platziert. Nun werden mit dem Dispenser glob tops aus der Harzmischung auf die Chips der Roh-LED packages getropft. Diese beschichteten LEDs werden im Trockenschrank bei 150°C über 1 Stunde temperiert. Dabei härtet das Harz (= Vergussmasse) aus.

Anschließend werden wiederum 50 ml der beiden Harzkomponenten JCR 6122 a und b mit 4 Gew. % der unbeschichteten Glas- bzw. Silicapartikel bzw. die nach Beispiel 1 A, B, oder C kompatibilisierten plättchenförmigen Glas- und/oder Silicapartikel gemischt. Die beiden Harzmischungen werden vereinigt, gerührt und entgast. Danach werden 10 ml in das Vorratsgefäß eines Jetdispensers oder Schraubendosierventildispensers gefüllt. Unter das Dispensventil werden die beschichteten LEDs platziert. Nun werden mit dem Dispenser die Diffusionssperrschichten bestehend aus der Harzmischung und den plättchenförmigen Partikeln auf die beschichteten LEDs gebracht. Diese beschichteten LEDs werden dann im Trockenschrank bei 150°C über 1 Stunde temperiert. Dabei härtet das Harz der Diffusionssperrschicht aus.

### Abbildungen

Im folgenden soll die Erfindung anhand mehrerer Ausführungsbeispiele näher erläutert werden. Es zeigen:
Abb. 1: Homogene Verteilung der Glas- bzw. Silica-Plättchen in der Silikon bzw. Epoxyharz-Matrix. 1: Silicon- / Epoxyharz, 2: Glas bzw. Silicaplättchen, 3: LED-Chip, 4: Leuchtstoffpartikel; B) Separate Diffusionssperrschicht; 5: Diffusionssperrschicht bestehend aus Silicon- / Epoxyharz-Matrix, die nur die plättchenförmigen Partikel beinhaltet; 6: eindiffundierendes Wasser.
Abb. 2: 1: Glas- oder Silicapartikel. Die plättchenförmigen Partikel sind parallel ausgerichtet und überlappen sich in vertikaler Richtung, so dass effektiv die Wasserdiffusion verhindert wird.

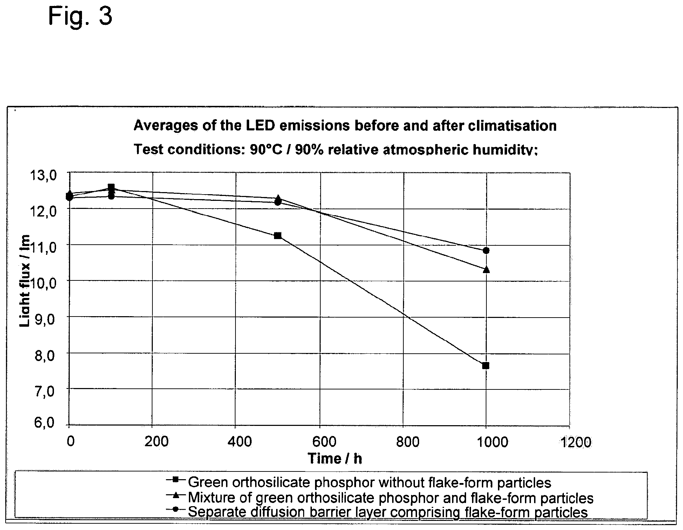

Abb.3: **1****:** Mittelwert der Messungen des Lichtstromes von 50 LEDs, welche eine separate Wasserdiffusions-Barriere-Schicht aufweisen.
   **2:** Mittelwert der Messungen des Lichtstromes von 50 LEDs, die eine Wasserdiffusions-Barriere aufweisen. Dabei wurde der grüne Orthosilikatleuchtstoff mit plättchenförmigen Partikeln gemischt.
   **3:** Mittelwert der Messungen des Lichtstromes von 50 LEDs, die keine Wasserdiffusions-Barriere aufweisen.

## Patentansprüche

1. Ein elektrolumineszierendes Bauelement mit einer Vergussmasse auf der Basis mindestens eines transparenten Silicon- oder Epoxyharzes enthaltend anorganische Leuchtstoffpartikel sowie Glas- und/oder Silicapartikel auf einer UV- oder blauen Leuchtdiode, **dadurch gekennzeichnet, dass** die Glas- und/oder Silicapartikel plättchenförmig sind und einen Durchmesser von 5 bis 20 µm und eine Dicke von 0,1 bis 5 µm besitzen.

2. Ein elektrolumineszierendes Bauelement nach Anspruch 1, **dadurch gekennzeichnet, dass** die Glas- und/oder Silicapartikel und die Leuchtstoffpartikel in der Vergussmasse homogen verteilt sind.

3. Ein elektrolumineszierendes Bauelement nach Anspruch 1, **dadurch gekennzeichnet, dass** die Glas- und/oder Silicapartikel in der Vergussmasse dispergiert und planparallel ausgerichtet sind und als separate Diffusionssperrschicht direkt auf einer zusätzlichen Vergussmasse, welche ausschließlich die Leuchtstoffpartikel enthält, angeordnet sind.

4. Ein elektrolumineszierendes Bauelement nach einem oder mehreren der Ansprüche 1 bis 3, **dadurch gekennzeichnet, dass** der mittlere Korndurchmesser d₅₀ der Leuchtstoffpartikel < 20 µm liegt.

5. Ein elektrolumineszierendes Bauelement nach einem oder mehreren der Ansprüche 1 bis 4, **dadurch gekennzeichnet, dass** die anorganischen Leuchtstoffpartikel aus folgender Gruppe ausgewählt sind:
(Y, Gd, Lu, Sc, Sm, Tb)₃ (AI, Ga)₅O₁₂:Ce (mit oder ohne Pr), (Ca, Sr, Ba)₂SiO₄:Eu, YSiO₂N:Ce, Y₂Si₃O₃N₄:Ce, Gd₂Si₃O₃N₄:Ce, (Y,Gd,Tb,Lu)₃Al₅₋ₓSiₓO₁₂₋ₓNₓ:Ce, BaMgAl₁₀O₁₇:Eu, SrAl₂O₄:Eu, Sr₄Al₁₄O₂₅:Eu, (Ca,Sr,Ba)Si₂N₂O₂:Eu, SrSiAl₂O₃N₂:Eu, (Ca,Sr,Ba)₂Si₅N₈:Eu, CaAlSiN₃:Eu, Zink-Erdalkaliorthosilikate, Kupfer-Erdalkaliorthosilikate, Eisen-Erdalkaliorthosilikate, Molybdate, Wolframate, Vanadate, Gruppe-III Nitride, Oxide, jeweils einzeln oder Gemischen derselben mit einem oder mehreren Aktivatorionen wie Ce, Eu, Mn, Cr und/oder Bi

6. Ein elektrolumineszierendes Bauelement nach Anspruch 5, **dadurch gekennzeichnet, dass** die anorganischen Leuchtstoffpartikel ortho-Silikate sind.

7. Verfahren zur Herstellung eines elektrolumineszierenden Bauelements nach einem oder mehreren der Ansprüche 1 bis 2 und 4 bis 6 mit einer Vergussmasse auf der Basis mindestens eines transparenten Silicon- oder Epoxyharzes enthaltend anorganische Leuchtstoffpartikel sowie Glas- und/oder Silicapartikel auf einer UV- oder blauen Leuchtdiode, **gekennzeichnet durch** die Verfahrensschritte:
a) homogenes Mischen anorganischer Leuchtstoffpartikel mit pulverförmigen Glas- und/oder Silicapartikeln
b) Dispergieren der Mischung aus Leuchtstoffen und Glas- und/oder Silicapartikeln mit dem transparenten Silicon- oder Epoxyharz.
c) Beschichten der blauen Leuchtdiode mit Silicon- oder Epoxyharz, welches den Leuchtstoff und die Glas- und/oder Silicapartikel enthält.
d) Aushärten der Beschichtung.

8. Verfahren zur Herstellung eines elektrolumineszierenden Bauelements nach einem oder mehreren der Ansprüche 1 und 3 bis 6 mit einer Vergussmasse auf der Basis mindestens eines transparenten Silicon- oder Epoxyharzes enthaltend anorganische Leuchtstoffpartikel sowie Glas- und/oder Silicapartikel auf einer UV- oder blauen Leuchtdiode, **gekennzeichnet durch** die Verfahrensschritte:
a) Dispergieren der anorganischen Leuchtstoffpartikel mit Silicon- oder Epoxyharz.
b) Beschichten der Leuchtdiode mit der Mischung aus Leuchtstoffpartikel und Silicon- oder Epoxyharz.
c) Aushärten der Beschichtung
d) Dispergieren der Glas- oder Silicapartikel in Silicon- oder Epoxyharz.
e) Herstellen einer Diffusionssperrschicht durch Beschichten der ausgehärteten Leuchtstoffbeschichtung
f) Aushärten der Diffusionssperrschicht.

9. Verfahren nach Anspruch 7 und/oder 8, **dadurch gekennzeichnet, dass** die Glas- und/oder Silicapartikel mit Silicium-organischen Verbindungen oberflächenbeschichtet werden.

## Claims

1. Electroluminescent component with an encapsulating composition based on at least one transparent silicone or epoxy resin comprising inorganic phosphor particles and glass and/or silica particles on a UV or blue light-emitting diode, **characterised in that** the glass and/or silica particles are in flake form and have a diameter of 5 to 20 µm and a thickness of 0.1 to 5 µm.

2. Electroluminescent component according to Claim 1, **characterised in that** the glass and/or silica particles and the phosphor particles are homogeneously distributed in the encapsulating composition.

3. Electroluminescent component according to Claim 1, **characterised in that** the glass and/or silica particles are dispersed and aligned in a plane-parallel manner in the encapsulating composition and are arranged as a separate diffusion barrier layer directly on an additional encapsulating composition which comprises exclusively the phosphor particles.

4. Electroluminescent component according to one or more of Claims 1 to 3, **characterised in that** the average particle diameter d₅₀ of the phosphor particles is < 20 µm.

5. Electroluminescent component according to one or more of Claims 1 to 4, **characterised in that** the inorganic phosphor particles are selected from the following group:
(Y, Gd, Lu, Sc, Sm, Tb)₃ (Al, Ga)₅O₁₂:Ce (with or without Pr), (Ca, Sr Ba)₂SiO₄:Eu, YSiO₂N:Ce, Y₂Si₃O₃N₄:Ce, Gd₂Si₃O₃N₄:Ce, (Y,Gd,Tb,Lu)₃Al₅₋ₓSiₓO₁₂₋ₓNₓ:Ce, BaMgAl₁₀O₁₇:Eu, SrAl₂O₄:Eu, Sr₄Al₁₄O₂₅:Eu, (Ca,Sr,Ba)Si₂N₂O₂:Eu, SrSiAl₂O₃N₂:Eu, (Ca,Sr,Ba)₂Si₅N₈:Eu, CaAlSiN₃:Eu, zinc-alkaline-earth metal orthosilicates, copper-alkaline-earth metal orthosilicates, iron-alkaline-earth metal orthosilicates, molybdates, tungstates, vanadates, group III nitrides, oxides, in each case individually or mixtures thereof with one or more activator ions, such as Ce, Eu, Mn, Cr and/or Bi

6. Electroluminescent component according to Claim 5, **characterised in that** the inorganic phosphor particles are orthosilicates.

7. Process for the production of an electroluminescent component according to one or more of Claims 1 to 2 and 4 to 6 with an encapsulating composition based on at least one transparent silicone or epoxy resin comprising inorganic phosphor particles and glass and/or silica particles on a UV or blue light-emitting diode, **characterised by** the process steps:
a) homogeneous mixing of inorganic phosphor particles with pulverulent glass and/or silica particles
b) dispersal of the mixture of phosphors and glass and/or silica particles with the transparent silicone or epoxy resin
c) coating of the blue light-emitting diode with silicone or epoxy resin which comprises the phosphor and the glass and/or silica particles
d) curing of the coating.

8. Process for the production of an electroluminescent component according to one or more of Claims 1 and 3 to 6 with an encapsulating composition based on at least one transparent silicone or epoxy resin comprising inorganic phosphor particles and glass and/or silica particles on a UV or blue light-emitting diode, **characterised by** the process steps:
a) dispersal of the inorganic phosphor particles with silicone or epoxy resin.
b) coating of the light-emitting diode with the mixture of phosphor particles and silicone or epoxy resin
c) curing of the coating
d) dispersal of the glass or silica particles in silicone or epoxy resin
e) production of a diffusion barrier layer by coating the cured phosphor coating
f) curing of the diffusion barrier layer.

9. Process according to Claim 7 and/or 8, **characterised in that** the glass and/or silica particles are coated on the surface with organosilicon compounds

## Revendications

1. Composant électroluminescent avec une composition d'encapsulage qui est basée sur au moins une résine silicone ou époxy transparente qui comprend des particules de phosphore inorganiques et des particules de verre et/ou de silice sur une diode émettrice de lumière UV ou de lumière bleue, **caractérisé en ce que** les particules de verre et/ou de silice sont sous la forme de flocons et elles présentent un diamètre de 5 à 20 µm et une épaisseur de 0,1 à 5 µm.

2. Composant électroluminescent selon la revendication 1, **caractérisé en ce que** les particules de verre et/ou de silice et les particules de phosphore sont distribuées de façon homogène dans la composition d'encapsulage.

3. Composant électroluminescent selon la revendication 1, **caractérisé en ce que** les particules de verre et/ou de silice sont dispersées et alignées d'une manière à plans parallèles dans la composition d'encapsulage et sont agencées en tant que couche de barrière de diffusion séparée directement sur une composition d'encapsulage additionnelle qui comprend de façon exclusive les particules de phosphore.

4. Composant électroluminescent selon une ou plusieurs des revendications 1 à 3, **caractérisé en ce que** le diamètre de particule moyen d₅₀ des particules de phosphore est < 20 µm.

5. Composant électroluminescent selon une ou plusieurs des revendications 1 à 4, **caractérisé en ce que** les particules de phosphore inorganiques sont sélectionnées parmi le groupe qui suit :
(Y, Gd, Lu, Sc, Sm, Tb)₃ (Al, Ga)₅O₁₂:Ce (avec ou sans Pr), (Ca, Sr Ba)₂SiO₄:Eu, YSiO₂N:Ce, Y₂Si₃O₃N₄:Ce, Gd₂Si₃O₃N₄:Ce, (Y,Gd,Tb,Lu)₃Al₅₋ₓSiₓO₁₂₋ₓNₓ:Ce, BaMgAl₁₀O₁₇:Eu, SrAl₂O₄:Eu, Sr₄Al₁₄O₂₅:Eu, (Ca,Sr,Ba)Si₂N₂O₂:Eu, SrSiAl₂O₃N₂:Eu, (Ca,Sr,Ba)₂Si₅N₈:Eu, CaAlSiN₃:Eu, les orthosilicates de zinc-alcalino-terreux, les orthosilicates de cuivre-alcalino-terreux, les orthosilicates de fer-alcalino-terreux, les molybdates, les tungstates, les vanadates, les nitrures du groupe III, les oxydes, dans chaque cas de façon individuelle ou selon des mélanges afférents avec un ou plusieurs ion(s) activateur(s), tels que Ce, Eu, Mn, Cr et/ou Bi.

6. Composant électroluminescent selon la revendication 5, **caractérisé en ce que** les particules de phosphore inorganiques sont des orthosilicates.

7. Procédé pour la production d'un composant électroluminescent selon une ou plusieurs des revendications 1 et 2 et 4 à 6 avec une composition d'encapsulage qui est basée sur au moins une résine silicone ou époxy transparente qui comprend des particules de phosphore inorganiques et des particules de verre et/ou de silice sur une diode émettrice de lumière UV ou de lumière bleue, **caractérisé par** les étapes de procédé qui sont constituées par :
a) le mélange homogène de particules de phosphore inorganiques avec des particules de verre et/ou de silice pulvérulentes ;
b) la dispersion du mélange de particules de phosphore et de particules de verre et/ou de silice avec la résine silicone ou époxy transparente ;
c) le revêtement de la diode émettrice de lumière bleue avec la résine silicone ou époxy qui comprend les particules de phosphore et les particules de verre et/ou de silice ; et
d) le durcissement du revêtement.

8. Procédé pour la production d'un composant électroluminescent selon une ou plusieurs des revendications 1 et 3 à 6 avec une composition d'encapsulage qui est basée sur au moins une résine silicone ou époxy transparente qui comprend des particules de phosphore inorganiques et des particules de verre et/ou de silice sur une diode émettrice de lumière UV ou de lumière bleue, **caractérisé par** les étapes de procédé qui sont constituées par :
a) la dispersion des particules de phosphore inorganiques avec une résine silicone ou époxy ;
b) le revêtement de la diode émettrice de lumière avec le mélange de particules de phosphore et de résine silicone ou époxy ;
c) le durcissement du revêtement ;
d) la dispersion des particules de verre ou de silice dans la résine silicone ou époxy ;
e) la production d'une couche de barrière de diffusion par dépôt du revêtement de phosphore durci ; et
f) le durcissement de la couche de barrière de diffusion.

9. Procédé selon la revendication 7 et/ou 8, **caractérisé en ce que** les particules de verre et/ou de silice sont revêtues sur la surface avec des composés d'organosilicium.
